# EUROPÄISCHE PATENTANMELDUNG

(11) **EP 0 766 351 A1**
(43) Veröffentlichungstag der Anmeldung: **02.04.1997**
(21) Anmeldenummer: 96113360.0
(22) Anmeldetag: 21.08.1996
(51) Int. Cl.: H01R 13/717, H01R 13/03

(54) **Statusanzeigeeinrichtung für Leiterplattenanschlusselemente**

(30) Priorität: 26.09.1995 DE 19535714
(71) Anmelder: Weidmüller Interface GmbH & Co., D-32760 Detmold (DE)
(72) Erfinder: Scheffner, Wolfgang, 64859 Eppertshausen (DE)
(74) Vertreter: Stracke, Alexander, Dipl.-Ing.

(57) **Zusammenfassung**

Bei dieser Statusanzeigeeinrichtung für Leiterplattenanschlußelemente, beispielsweise in Form einer Stiftleiste, ist das Kunststoffgehäuse (2) der Stiftleiste (1) unmittelbar mit Leiterbahnen (5) derart metallisiert, daß diese einerseits den mit der Leiterplatte zu kontaktierenden Stift (3) kontaktieren und andererseits auf dem Kunststoffgehäuse (2) zu einer optisch gut sichtbaren Stelle geführt sind und hier mit Leuchtdioden (6) bestückt sind. Die gesamte Statusanzeigeeinrichtung ist damit mit dem Leiterplattenanschlußelement integriert, erfordert keine zusätzlichen Bauteile und keinen zusätzlichen Platz auf der Leiterplatte.

## Beschreibung

Die vorliegende Erfindung betrifft eine Statusanzeigeeinrichtung für Leiterplattenanschlußelemente. Bei Leiterplattenanschlußelementen, beispielsweise Leiterplattensteckverbindern, ist eine optische Anzeige des Spannungszustandes erwünscht. Dies setzt voraus, daß die Anzeige an einer optisch gut sichtbaren Stelle erfolgen kann. Dazu ist es bekannt (EP 0 365 698 A1), auf der Leiterplatte hinter dem Leiterplattenanschlußelement Leuchtdioden anzubringen, deren Licht dann mit Hilfe von Adapterteilen aus lichtleitendem Material, die auf der Rückseite der Leiterplattenanschlußelemente aufgesetzt werden, an die gewünschte, optisch gut wahrnehmbare Stelle geleitet wird, beispielsweise an Durchbrüche von Frontplatten eines Gerätes oder dergleichen. Es sind auch Statusanzeigeeinrichtungen bekannt, in denen Leuchtdioden mit sehr langen Anschlußbeinen in besonderen, wieder auf die Leiterplattenanschlußelemente aufzusetzenden Adapterteilen angeordnet werden. Die Anschlußbeine der Leuchtdioden werden dann mit der Leiterplatte verbunden (DE 40 35 369 C1). In jedem Fall werden zusätzliche, komplizierte und in der Herstellung teure Bauelemente benötigt und beträchtlicher Raum auf der Leiterplatte selbst für die Statusanzeige verbraucht.

Der vorliegenden Erfindung liegt von daher die Aufgabe zugrunde, eine Statusanzeigeeinrichtung zu schaffen, die einen denkbar einfachen Aufbau hat, leicht herzustellen ist und zu erheblicher Platzersparnis auf der Leiterplatte führt.

Die erfindungsgemäße Lösung besteht im wesentlichen darin, daß das Kunststoffgehäuse der Leiterplattenanschlußelemente mit Leiterbahnen derart metallisiert ist, daß diese die elektrisch mit der Leiterplatte zu kontaktierenden Anschlußteile des Leiterplattenanschlußelementes kontaktieren, auf dem Gehäuse zu optisch gut sichtbaren Stellen geführt sind und an diesen mit Leuchtdioden bestückt sind. Eine derartige Statusanzeigeeinrichtung hat insoweit einen denkbar einfachen Aufbau, als zusätzliche komplizierte Bauelemente nicht mehr benötigt werden. Vielmehr befindet sich die Statusanzeigeeinrichtung in der Gesamtheit ihrer Bauelemente unmittelbar selbst auf und an dem Leiterplattenanschlußelement und zwar einerseits in Form der darauf metallisierten Leiterbahnen und andererseits in Form der Leuchtdioden und ggf. weiterer benötigter elektronischer Bauelemente, die dann auch auf diese Leiterbahnen gelötet werden können. Neben einer außerordentlich vereinfachten Montage mit sehr kurzen Bestückungszeiten und einer vereinfachten Lagerhaltung ergibt sich auch auf der Leiterplatte eine erhebliche Platzersparnis, da der bisherige Platzbedarf für die Statusanzeigeeinrichtung vollständig in Fortfall kommt. Darüberhinaus ergibt sich eine sehr hohe Qualität der Leuchtanzeige und bei entsprechender Ausgestaltung eine universelle Einsetzbarkeit einer derartigen Statusanzeigeeinrichtung bei unterschiedlichen Signalpegeln. Die vorhandenen Technologien zur Herstellung derartiger als dreidimensionaler Leiterplatten zu bezeichnender Gebilde, hier dann in Form von Leiterplattenanschlußelementen, ermöglichen eine preiswerte Herstellung beispielsweise einer auf einer Leiterplatte anzuordnenden Stiftleiste mit allen Leiterbahnen, die einerseits für die unmittelbare Bestückung der Stiftleiste mit Leuchtdioden an optisch gut sichtbarer Stelle und andererseits für die Kontaktierung der Stifte der Stiftleiste erforderlich sind, deren Spannungszustand durch die Leuchtdioden signalisiert werden soll.

Weitere zweckmäßige Ausgestaltungen sind in den Unteransprüchen gekennzeichnet.

Ausführungsbeispiele derartiger Statusanzeigeeinrichtungen werden nachstehend unter Bezugnahme auf die Zeichnung näher beschrieben.

Es zeigen:
- Figuren 1 + 2: eine perspektivische Vorder- und Rückansicht eines Leiterplattenanschlußelementes mit Statusanzeigeeinrichtung gemäß der Erfindung,
- Figur 3: einen Querschnitt durch das Leiterplattenanschlußelement nach Figur 2 zur Illustration eines Leiterbahnenverlaufes,
- Figur 4: eine weitere Ausführungsform eines derartigen Leiterplattenanschlußelementes in perspektivischer Darstellung.

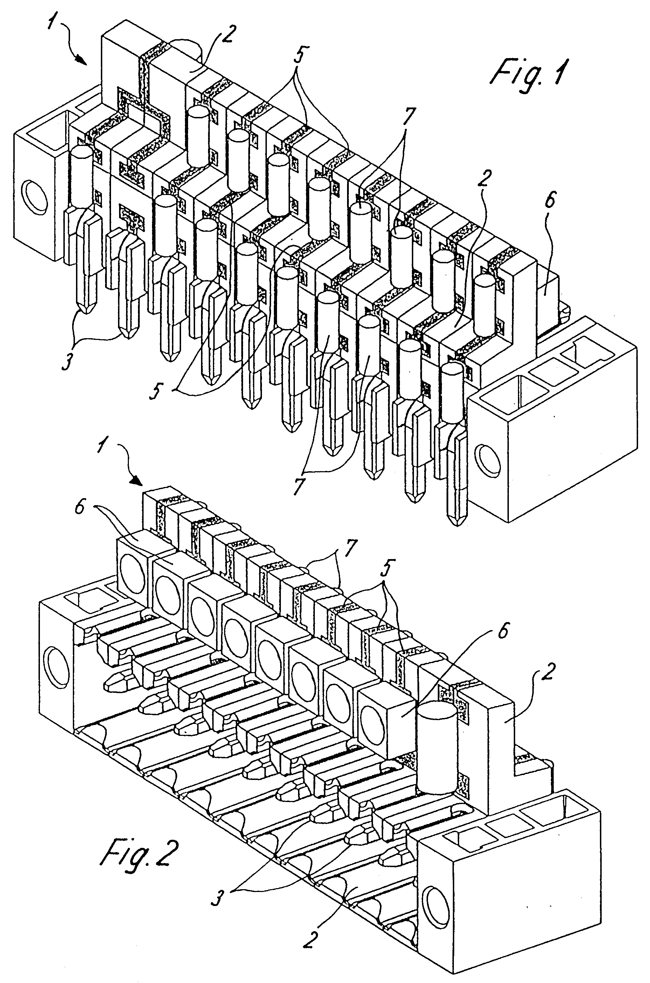

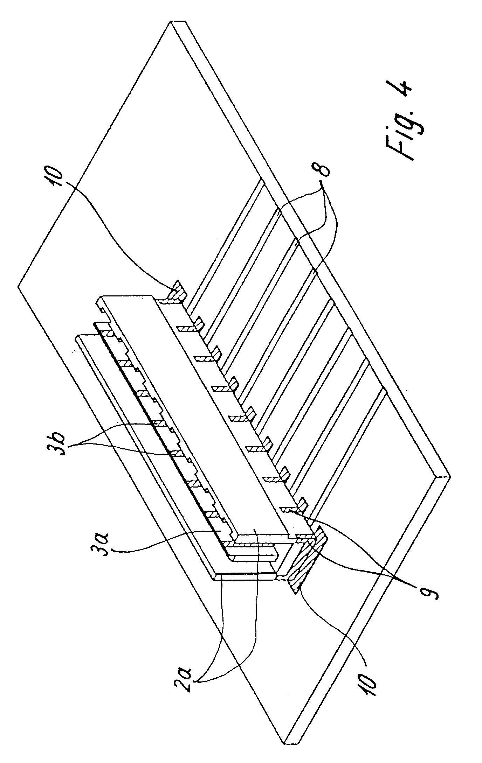

Als mögliches Ausführungsbeispiel für ein Leiterplattenanschlußelement ist in den Figuren 1 bis 3 eine Stiftleiste 1 gezeigt, in deren Kunststoffgehäuse 2 abgewinkelte Stifte 3 angeordnet sind, deren eines Ende der Steckverbindung mit dem anzuschließenden Steckverbinderelement dient und deren anderes Ende der Einsteckung und Kontaktierung mit einer Leiterplatte 4 (s. z. B. Figur 4) dient.

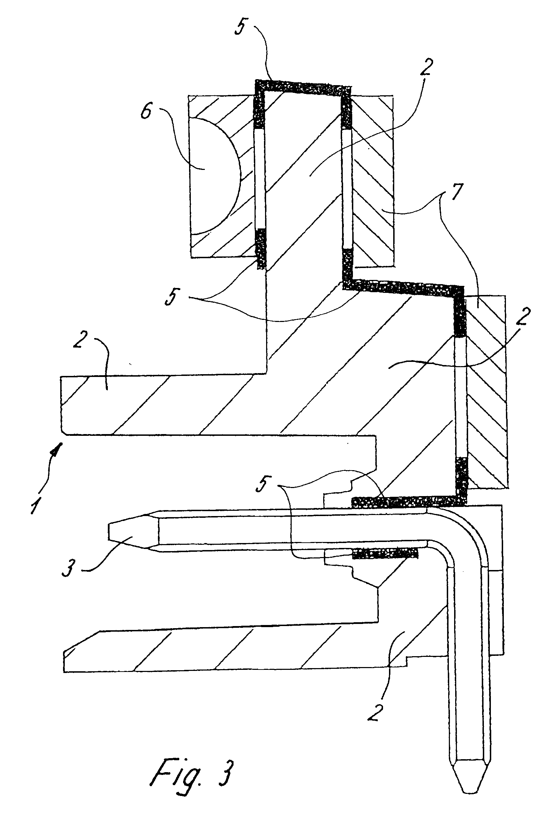

Auf das Kunststoffgehäuse 2 der Stiftleiste 1 sind nun Leiterbahnen 5 unmittelbar aufmetallisiert, und zwar derart, daß diese Leiterbahnen einerseits, wie insbesondere aus Figur 3 ersichtlich, die in diesem Ausführungsbeispiel stiftförmigen Anschlußteile 3 kontaktieren, deren Spannungszustand ja überprüft werden soll und sie andererseits über das Kunststoffgehäuse 2 zu einer optisch gut sichtbaren Stelle, beispielsweise am oberen Frontbereich des Kunststoffgehäuses 2 geführt sind, wo dann zur Statusanzeige des Spannungszustandes die Leiterbahnen 5 und damit die Stiftleiste 1 selbst mit Leuchtdioden 6 bestückt werden, beispielsweise durch Auflöten der Leuchtdioden 6 auf die entsprechende Stelle der Leiterbahn 5. Auf die Leiterbahnen 5 auf dem Kunststoffgehäuse 2 werden weitere für die funktionsgerechte Ausgestaltung benötigte elektronische Bauteile 7 direkt auf entsprechende Abschnitte der Leiterbahnen 5 aufgelötet.

Die Anschauung zeigt, daß sich alle Elemente der Statusanzeigeeinrichtung direkt an und auf der Stiftleiste 1 selbst befinden, so daß für die Statusanzeigeeinrichtung auf der Leiterplatte selbst kein zusätzlicher Platz benötigt wird.

Nach der heutigen Technologie bieten sich zwei Alternativverfahren des Zwei-Komponenten-Spritzgießens für derartige Bauteile, die man als dreidimensionale Leiterplatten bezeichnen kann, an. Es kann beispielsweise für das Leiterbahngerippe katalytischer Kunststoff verwendet werden. Das Kunststoffteil als solches wird mit einem ersten Schuß und direkt daran anschließend mit einem zweiten Schuß komplett fertiggespritzt. Anschließend wird metallisiert.

Es ist auch möglich, für das Leiterbahngerippe nichtkatalytischen Kunststoff zu verwenden. Nach dem Spritzen des Leiterbahngerippes wird dann dieses katalysiert und erst dann erfolgt der zweite Schuß mit nichtkatalytischem Material zur Ausbildung des Kunststoffteiles. Anschließend wird metallisiert.

Aus Vorstehendem ergibt sich, daß auch eine Ausführungsform möglich ist, bei der von vornherein die eigentliche Leiterplatte einstückig als Gesamtformkörper mit dem Leiterplattenanschlußelement ausgebildet ist.

In Abwandlung des vorstehend beschriebenen Ausführungsbeispiels ist es, wenn man beim Beispiel eines Leiterplattenanschlußelementes in Form einer Stiftleiste bleibt, auch möglich, die Stifte 3 durch Kunststoffstifte oder zweckmäßig eine Kunststoffrippe 3a zu ersetzen, wie in Figur 4 dargestellt, auf der sich dann jeweils in entsprechender Stiftkonfiguration quasi als Stifte Leiterbahnen 3b befinden, die so durch das Kunststoffgehäuse 2a nach unten zur Leiterplatte 4 geführt sind, daß sie dort direkt Leiterbahnen 8 kontaktieren. Es ist in Figur 4 zur Illustration des vorstehend Gesagten nur dieser untere Kontaktbereich zwischen Kunststoffgehäuse 2a und Leiterplatte 4 dargestellt. Im oberen Bereich eines solchen Leiterplattenanschlußelementes kann dann auf die grundsätzliche Konfiguration des Ausführungsbeispieles nach den Figuren 1 und 2 zurückgegriffen werden.

In weiterer Ausgestaltung des Ausführungsbeispieles nach Figur 2 kann es zweckmäßig sein, an vorgegebenen Bereichen des Kunststoffgehäuses 2a Lötflächen 9 und an vorgegebenen Bereichen der Leiterplatte 4 Lötflächen 10 vorzusehen, deren Verlötung der mechanischen Festsetzung des Leiterplattenanschlußelementes auf der Leiterplatte dient. Dadurch kann das Leiterplattenanschlußelement sowohl mechanisch wie elektrisch in einem Arbeitsgang mit der Leiterplatte beispielsweise im sogenannten Oberflächenmontageverfahren verbunden werden.

## Patentansprüche

1. Statusanzeigeeinrichtung für Leiterplattenanschlußelemente, **dadurch gekennzeichnet, daß** das Kunststoffgehäuse (2, 2a) der Leiterplattenanschlußelemente mit Leiterbahnen (5) derart metallisiert ist, daß diese die elektrisch mit der Leiterplatte zu kontaktierenden Anschlußteile (3, 3b) der Leiterplattenanschlußelemente kontaktieren, auf dem Gehäuse (2) zu optisch gut sichtbaren Stellen geführt und an diesen mit Leuchtdioden (6) bestückt sind.

2. Statusanzeigeeinrichtung nach Anspruch 1, **dadurch gekennzeichnet, daß** die Leiterbahnen (5) auf dem Kunststoffgehäuse (2) bis in den oberen Frontbereich des Kunststoffgehäuses (2) geführt und hier mit den Leuchtdioden (6) bestückt sind.

3. Statusanzeigeeinrichtung nach einem der vorhergehenden Ansprüche, **dadurch gekennzeichnet, daß** bei Ausbildung des Leiterplattenanschlußelementes als Stiftleiste (1) die Leiterbahnen (5) im Kunststoffgehäuse (2) kontaktierend an die mit der Leiterplatte (4) zu verbindenden Stifte (3) geführt sind.

4. Statusanzeigeeinrichtung nach einem der vorhergehenden Ansprüche, **dadurch gekennzeichnet, daß** die Leiterbahnen (5) auf dem Kunststoffgehäuse (2) in ihrem Verlauf mit weiteren elektronischen Bauteilen (7) bestückt sind.

5. Statusanzeigeeinrichtung nach einem der vorhergehenden Ansprüche, **dadurch gekennzeichnet, daß** die Anschlußteile des Leiterplattenanschlußelementes durch eine Kunststoffverrippung (3a) gebildet sind, die im Anschlußraster mit Leiterbahnen (3b) metallisiert ist, die durch das Kunststoffgehäuse (2a) zur Kontaktierung auf die Unterseite bis zu den Leiterbahnen (8) auf der Leiterplatte (4) führen.

6. Statusanzeigeeinrichtung nach einem der vorhergehenden Ansprüche, **dadurch gekennzeichnet, daß** das Leiterplattenanschlußelement und die Leiterplatte einstückig zu einer dreidimensionalen Gesamtkonfiguration geformt sind.

7. Statusanzeigeeinrichtung nach einem der Ansprüche 1 bis 6, **dadurch gekennzeichnet, daß** das Kunststoffgehäuse (2a) des Leiterplattenanschlußelementes und die Leiterplatte (4) zur mechanischen Festlegung aneinander mit zusammenwirkenden Lötflächen (9 und 10) versehen sind.
